Europäisches Patentamt

European Patent Office

Office européen des brevets

(19)

(11) **EP 0 701 331 B1**

(12) **EUROPÄISCHE PATENTSCHRIFT**

(45) Veröffentlichungstag und Bekanntmachung des Hinweises auf die Patenterteilung:
**27.02.2002 Patentblatt 2002/09**

(51) Int Cl.[7]: **H03M 1/82**, G09G 3/36

(21) Anmeldenummer: **95113593.8**

(22) Anmeldetag: **30.08.1995**

(54) **Verfahren und Schaltungsanordnung zur Wandlung eines digitalen Datenwortes mit N Bit in einen analogen Spannungswert**

Method and circuit for the conversion of a digital word of N-bits in an analog voltage value

Procédé et dispositif de circuit de conversion d'un mot numérique à N-bit en valeur de tension analogique

(84) Benannte Vertragsstaaten:
**DE FR GB NL**

(30) Priorität: **09.09.1994 DE 4432065**

(43) Veröffentlichungstag der Anmeldung:
**13.03.1996 Patentblatt 1996/11**

(73) Patentinhaber: **Universität Stuttgart**
**70174 Stuttgart (DE)**

(72) Erfinder:
• **Lüder, Ernst, Prof. Dr. Ing. habil.**
**70192 Stuttgart (DE)**

• **Kull, Stefan, Dipl.-Ing.**
**D-70374 Stuttgart (DE)**

(74) Vertreter: **Möbus, Rudolf, Dipl.-Ing. et al**
**Dipl.-Ing. Rudolf Möbus, Dr.-Ing. Daniela Möbus, Dipl.-Ing. Gerhard Schwan, Hindenburgstrasse 65**
**72762 Reutlingen (DE)**

(56) Entgegenhaltungen:
**WO-A-92/07352          US-A- 3 887 911**
**US-A- 4 126 853          US-A- 4 742 346**

**Beschreibung**

Die Erfindung betrifft ein Verfahren und eine Schaltungsanordnung zur Wandlung eines digitalen Datenwortes mit N Bit in einen analogen Spannungswert durch Vergleich des digitalen Datenwortes mit einer analogen Referenzspannung mit rampenförmigem zeitlichen Verlauf.

Digital/Analog-Wandlungen werden bei einer Vielzahl von Steuerungsaufgaben und in der Telekommunikation durchgeführt. Ein besonderer Anwendungsbereich ist die digitale Ansteuerung der Datenleitungen eines Flüssigkristall-Bildschirms. Sogenannte Aktiv-Matrix-Flüssigkristall-Bildschirme, kurz auch als AM-LCDs bezeichnet, werden zukünftig aufgrund einer Vielzahl von Vorteilen im Fernseh- und Datenverarbeitungsbereich zunehmend die herkömmlichen Bildschirme mit Kathodenstrahlröhre ersetzen. Zu den Vorteilen der Flüssigkristall-Bildschirme zählen die flache und leichte Bauweise, die Möglichkeit der verzerrungsfreien Darstellung von Bildern, geringe Ansteuerspannungen und infolge hiervon eine geringe Leistungsaufnahme, eine hohe Auflösung, das Fehlen von Röntgenstrahlen und starken elektromagnetischen Feldern im Umfeld des Bildschirms sowie die Möglichkeit einer Herstellung in einer preiswerten Technologie. Flüssigkristall-Bildschirme können auch als Lichtventil in einem Projektor für die großformatige Darstellung von Videobildern eingesetzt werden.

Flüssigkristall-Bildschirme bestehen aus einer matrixförmigen Anordnung von Bildpunkten, wobei jedem Bildpunkt ein Schaltelement zugeordnet ist. Häufig werden Dünnfilmtransistoren als Schaltelemente verwendet. Die Bildinformation wird an Spaltenleitungen angelegt und zeilenweise über die Schaltelemente in die Bildpunktspeicher geschrieben. Daher müssen die n Zeilenleitungen so angesteuert werden, dass jeweils nur eine Zeilenleitung der insgesamt n Zeilen des Bildschirms für 1/n-tel der Bilddauer ein genügend hohes Potential besitzt, sodass die Bildpunktkapazität über das Schaltelement auf die der Bildpunktinformation entsprechende Datenspannung aufgeladen werden kann. Während der restlichen Bildwiederholdauer, in welcher eine Zeile nicht selektiert ist, muss durch Ansteuerung der Zeile mit einer ausreichend niedrigen Spannung dafür gesorgt werden, dass die Bildpunktkapazität nicht über das Schaltelement entladen werden kann.

In der WO-A 92/07352 ist ein Verfahren zur Wandlung eines digitalen Datenwortes mit n Bit in einen analogen Spannungswert durch Vergleich des digitalen Datenwortes mit einer analogen Referenzspannung mit rampenförmigem zeitlichen Verlauf beschrieben. Dabei wird eine bitweise EXNOR-Verknüpfung des digitalen Datenwortes mit einem n-Bit-Zählerwort durchgeführt, das synchron zum zeitlichen Verlauf der Referenzspannung entweder inkrementiert oder dekrementiert wird. Sobald das Zählerwort einen Wert annimmt, der dem Komplement des Datenwortes entspricht, wird der dann erreichte Wert der Referenzspannung als analoger Spannungswert ausgegeben. Die Realisierung dieses Verfahrens mit EXNOR-Verknüpfungen ist jedoch schaltungstechnisch sehr aufwendig und insbesondere in Dünnschicht-Technologie nur schwierig durchzuführen.

Der Erfindung liegt daher die Aufgabe zugrunde, die Digital/-Analog-Wandlung mittels einer analogen Rampenspannung derart zu optimieren, dass nur noch ein äußerst geringer und in Dünnschichttechnologie leicht ausführbarer Schaltungsaufwand zu ihrer Realisierung notwendig ist.

Die Aufgabe wird mit einem Verfahren mit den Merkmalen des Anspruchs 1 gelöst. Die Schaltungsanordnung zur Durchführung dieses Verfahrens weist die Merkmale des Anspruchs 4 auf. Die Auswerteschaltung der Schaltungsanordnung kann bei Verwendung von NAND-Gattern mindestens eine Kapazität und N+3 weitere Schaltungselemente aufweisen, die Schalter beispielsweise in Form von Transistoren sein können.

Anstelle der naheliegenden aber relativ aufwendigen bitweisen Äquivalenz-Verknüpfung des digitalen Datenwortes mit einem Zählerwort wird beim erfindungsgemäßen Verfahren eine einfache bitweise logische Verknüpfung der beiden Worte durchgeführt, wobei das Zählerwort von seinem Maximalwert ausgehend dekrementiert oder von seinem Minimalwert ausgehend inkrementiert wird. Hierbei werden die folgenden mathematischen Sätze ausgenutzt:

　　　1. "Seien A und B zwei N-stellige Binärzahlen, so ist B = A die größte N-stellige Binärzahl, für die bei einer bitweisen NAND-Verknüpfung von A und B die Ausgänge aller NAND-Gatter eine logische "1" liefern bzw. bei einer bitweisen AND-Verknüpfung von A und B die Ausgänge aller AND-Gatter eine logische "0" liefern."

　　　2. "Seien A und B zwei N-stellige Binärzahlen, so ist B = Ā die kleinste N-stellige Binärzahl, für die bei einer bitweisen OR-Verknüpfung von A und B die Ausgänge aller OR-Gatter eine logische "1" liefern bzw. bei einer bitweisen NOR-Verknüpfung von A und B die Ausgänge aller NOR-Gatter eine logische "0" liefern."

Satz 1 läßt sich wie folgt verifizieren:
Seien A und B zwei Binärzahlen mit jeweils N Bit

$$A = \sum_i a_i \cdot 2^i; \quad B = \sum_i b_i \cdot 2^i,$$

wobei $a_i$, $b_i \in \{0,1\}$ gilt, so ergibt sich für die bitweise NAND-Verknüpfung der beiden Zahlen A und B mit Ergebnis "11.1", also

$\overline{A \cdot B}$ = "11.1" oder anders formuliert

$\overline{a_i \cap b_i}$ = 1 für alle $i \in \{0,1,...,N-1\}$,

daß dies unter folgenden Bedingungen erfüllt ist

$$\Big(\big(a_i = 0\big) \wedge b_i \in \{0,1\}\Big) \vee \Big(\big(a_i = 1\big) \wedge \big(b_i = 0\big)\Big).$$

Hieraus ist unschwer zu erkennen, daß sich bei gegebenem N-stelligen A mit

$$A = \sum_k a_k \cdot 2^k + \sum_j a_j \cdot 2^j = \sum_i a_i \cdot 2^i,$$

wobei ohne Beschränkung der Allgemeinheit gelte:

$a_k = 1$; $a_j = 0$; $k \neq j$ und $k, j \in \{0,1,...,N-1\}$

für das größte N-stellige B,

$$B = \sum_k b_k \cdot 2^k + \sum_j b_j \cdot 2^j = \sum_i b_i \cdot 2^i$$

welches für alle $i \in \{0,1,...,N-1\}$ die Bedingung

$\overline{a_i \cap b_i}$ = 1 erfüllt, folgende Bedingungen ergeben:

1. $b_k = \overline{a_k}$ (notwendig, um die Bedingung $\overline{a_k \cap b_k}$ = 1 zu erfüllen)

2. $b_j = \overline{a_j}$ (wegen $a_j = 0$ nicht notwendig, um die Bedingung $\overline{a_j \cap b_j}$ = 1 zu erfüllen, aber notwendig, um <u>größtes</u> B zu erhalten, welches die Bedingung $\overline{a_j \cap b_j}$ = 1 erfüllt) d. h. $b_i = \overline{a_i}$ für alle $i \in \{0,1,...,N-1\}$.

Die zweite Variante von Satz 1 sowie Satz 2 lassen sich aus der obengenannten Verifikation durch die Beziehungen

$\overline{a_i \cap b_i} = \overline{(a_i \cap b_i)}$      für die UND-Verknüpfung

$\overline{a_i \cap b_i} = \overline{a_i} \cup \overline{b_i}$      für die OR-Verknüpfung

und

$$\overline{a_i \cap b_i} = \overline{\left(\overline{\overline{a_i} \cup \overline{b_i}}\right)}$$

für die NOR-Verknüpfung

ebenfalls verifizieren.

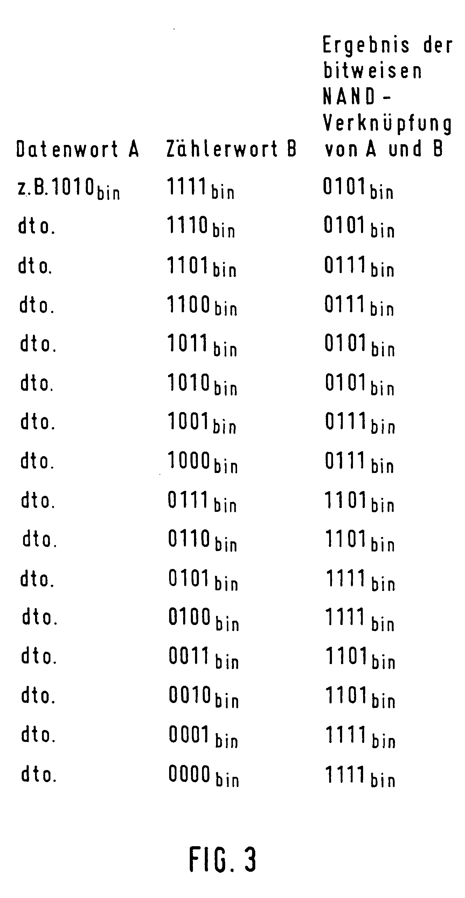

Wegen Gültigkeit dieser Sätze, die auch anhand der Tabelle in Fig. 3 für die NAND-Verknüpfung verifiziert werden können, und dem Dekrementieren bzw. Inkrementieren des Zählers ist sichergestellt, daß sobald das Zählerwort dem Komplement des digitalen Datenwortes entspricht, zum erstenmal während des Zählvorgangs alle Ausgänge der logischen Gatter gleichzeitig eine logische "1" bzw. eine logische "0" liefern. Der zu diesem Zeitpunkt von der Referenzspannung erreichte Wert wird anschließend als der dem digitalen Datenwort entsprechende analoge Spannungswert ausgegeben. Zwar liefern die Ausgänge der Gatter im weiteren Verlauf des Zählens erneut alle gemeinsam eine logische "1" bzw. eine logische "0", diese Zustände werden jedoch nicht mehr ausgewertet.

Die Aufwandsreduktion bei einer erfindungsgemäßen Schaltungsanordnung ist vor allem darauf zurückzuführen, daß wegen Gültigkeit der Sätze 1 und 2 einfachste, mit wenig Bauelementen realisierbare logische Verknüpfungen wie AND, NAND, OR oder NOR Verwendung finden können.

Zur Verdeutlichung der Aufwandsreduktion durch eine Schaltungsanordnung zur Durchführung des erfindungsgemäßen Verfahrens sei darauf hingewiesen, daß das naheliegendere Verfahren der bitweisen Äquivalenz-Verknüpfung von Datenwort und Zählerwort zu seiner Realisierung eine Schaltungsanordnung mit 3N NAND-Gattern und 2N Invertern im Gegensatz zu den nur N logischen Gattern und der Auswerteschaltung mit einer Kapazität und höchstens N+3 weiteren Schaltelementen der erfindungsgemäßen Schaltungsanordnung benötigt.

Weitere Vorteile ergeben sich, wenn der rampenförmige zeitliche Verlauf der Referenzspannung nichtlinear ist. Da die Zählschritte beim Dekrementieren des Zählers zeitlich äquidistant sind, ergeben sich bei einer linearen Rampenspannung auch äquidistante realisierbare analoge Spannungswerte. Bei Verwendung einer nichtlinearen Referenzspannung kann in bestimmten Spannungsbereichen eine höhere Auflösung von Analogwerten erreicht werden. Es können auch mehrere Referenzspannungen mit unterschiedlichem zeitlichen Verlauf zur Auswahl zur Verfügung stehen. Im Gegensatz zu anderen Digital/Analog-Wandlungsverfahren ist die Wandlerkennlinie beim erfindungsgemäßen Verfahren leicht zu variieren. Die Schaltungsanordnung zur Durchführung des Verfahrens kann in Dünnfilmtechnologie realisiert sein. Sie eignet sich dann für eine digitale Ansteuerschaltung für die Datenleitungen eines Flüssigkristall-Bildschirms mit matrixförmiger Anordnung von Bildpunkten, die neben einer erfindungsgemäßen Schaltungsanordnung je Datenleitung einen Speicher für ein digitales Datenwort und einen mit allen Schaltungsanordnungen der Datenleitungen verbundenen Zähler aufweist. Eine solche digitale Ansteuerschaltung weist gegenüber den bekannten Ansteuerschaltungen dieser Art den Vorteil auf, daß lediglich ein Zähler für sämtliche Datenleitungen des Bildschirms erforderlich ist. Die Ansteuerschaltung kann vorteilhafterweise mit der Bildpunktmatrix des Flüssigkristall-Bildschirms auf einem gemeinsamen Substrat und in einem gemeinsamen Dünnfilmtechnologieprozeß herstellbar sein. Dabei nimmt sie aufgrund der nur wenige Bauteile aufweisenden Digital/Analog-Wandler nur eine geringe Fläche auf dem Substrat ein. Der für alle Datenleitungen gemeinsame Zähler muß nicht auf dem Substrat mitintegriert sein.

Nachfolgend wird die Erfindung anhand der beiliegenden Zeichnung näher erläutert.

Es zeigen:

Fig. 1    Prinzipschaltbild einer erfindungsgemäßen Schaltungsanordnung;

Fig. 2    zeitlicher Verlauf der Spannungen der Schaltungsanordnung nach Fig. 1;

Fig. 3    eine Tabelle der bitweisen NAND-Verknüpfung eines Datenwortes mit einem Zählerwort;

Fig. 4    Ansteuerschaltung einer Datenleitung eines Flüssigkristall-Bildschirms;

Fig. 5    zeitliche Verläufe der Spannungen der Schaltung nach Fig. 4;

Fig. 6    Referenzspannung mit linearem rampenförmigen zeitlichen Verlauf;

Fig. 7    Referenzspannung mit nichtlinearem rampenförmigen zeitlichen Verlauf;

Fig. 8    Ansteuerschaltung einer Datenleitung eines Flüssigkristall-Bildschirms mit Wahlmöglichkeit zwischen zwei Referenzspannungen;

Fig. 9    verallgemeinertes Prinzipschaltbild einer erfindungsgemäßen Schaltungsanordnung.

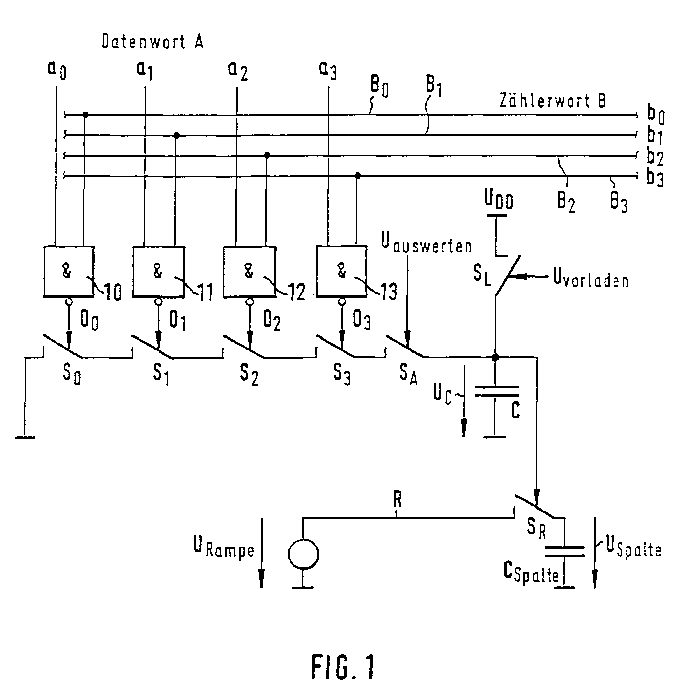

Der in Fig. 1 gezeigte Digital/Analog-Wandler besitzt N=4 NAND-Gatter 10 bis 13, auf deren ersten Eingang jeweils ein Bit $a_0$, $a_1$, $a_2$, $a_3$ eines Datenwortes A gegeben wird. Der zweite Eingang der NAND-Gatter 10 bis 13 wird über mit einem nicht näher dargestellten Zähler verbundenen Leitungen $B_0$ bis $B_3$ mit den entsprechenden Bits $b_0$ bis $b_3$ des Zählerwortes B beschaltet. Während das Datenwort A in einen nicht näher dargestellten Speicher eingelesen wird, wird eine Kapazität C des Digital/Analog-Wandlers über einen Schalter $S_L$ auf die Batteriespannung $U_{DD}$ aufgeladen. Dadurch wird ein Schalter $S_R$ geschlossen, und die Ausgangsspannung des Digital/Analog-Wandlers $U_{Spalte}$ wird über ihn mit einer Leitung R elektrisch verbunden, die eine rampenförmige Referenzspannung $U_{Rampe}$ führt. Ein Schalter $S_A$ ist in dieser Phase offen und verhindert damit ein Entladen der Kapazität C. Wenn das Datenwort A vollständig eingelesen ist, beginnt die Digital/Analog-Wandlung. Die Referenzspannung $U_{Rampe}$ durchläuft den gesamten Bereich von einem Minimalwert $U_{min}$ bis zu einem Maximalwert $U_{max}$, wobei die Spannungswerte im dargestellten Beispiel verschiedenen, auf einem Flüssigkristall-Bildschirm darstellbaren Grauwerten entsprechen. Sobald die Rampenspannung $U_{Rampe}$ anzusteigen beginnt, wird das Zählerwort B von seinem Maximalwert "1111" dekrementiert. In Abhängigkeit des aktuellen Zählerstandes führen somit die Zählerleitungen $B_0$ bis $B_3$ entweder ein hohes oder ein niedriges Potential. Über den Schalter $S_A$, der immer erst dann geschlossen wird, wenn sich die Ausgänge sämtlicher NAND-Gatter 10 bis 13 im eingeschwungenen Zustand befinden, wird verhindert, daß sich die Kapazität C beim Übergang von einem zum nächsten Zählerstand undefiniert entladen kann. Nimmt nun das Zählerwort B den Wert des Komplements $\bar{A}$ des Datenworts A an, so liegt an sämtlichen Ausgängen $O_0$ bis $O_3$ der NAND-Gatter 10 bis 13 zum erstenmal während der Digital/Analog-Wandlungsphase gleichzeitig eine logische "1" an. Sämtliche Schalter $S_0$ bis $S_3$ werden dadurch geschlossen. Außerdem wird auch der Schalter $S_A$ geschlossen, so daß sich die Kapazität C entladen kann. Der Schalter $S_R$ öffnet sich, wodurch der vor dem Öffnen von $S_R$ zuletzt erreichte Spannungswert der Referenzspannung $U_{Rampe}$ auf einer Kapazität $C_{Spalte}$ einer Bildschirmleitung als Spannungswert $U_{Spalte}$ gespeichert bleibt. $U_{Spalte}$ ist somit der dem digitalen Datenwort A entsprechende analoge Spannungswert.

Die in Fig. 1 dargestellte Schaltung ist vollständig in Dünnfilmtechnologie herstellbar unter Verwendung der bei dieser Technologie üblichen Materialien wie polykristalline Halbleiter, z. B. polykristallines Silizium oder amorphe Halbleiter wie amorphes Silizium. Im in Fig. 1 dargestellten Beispiel ist der Digital/Analog-Wandler zur Ansteuerung einer Spalte eines Flüssigkristall-Bildschirms vorgesehen. Es sind jedoch auch alle anderen Aufgaben einer Digital/Analog-Wandlung mit der dargestellten Schaltung verwirklichbar.

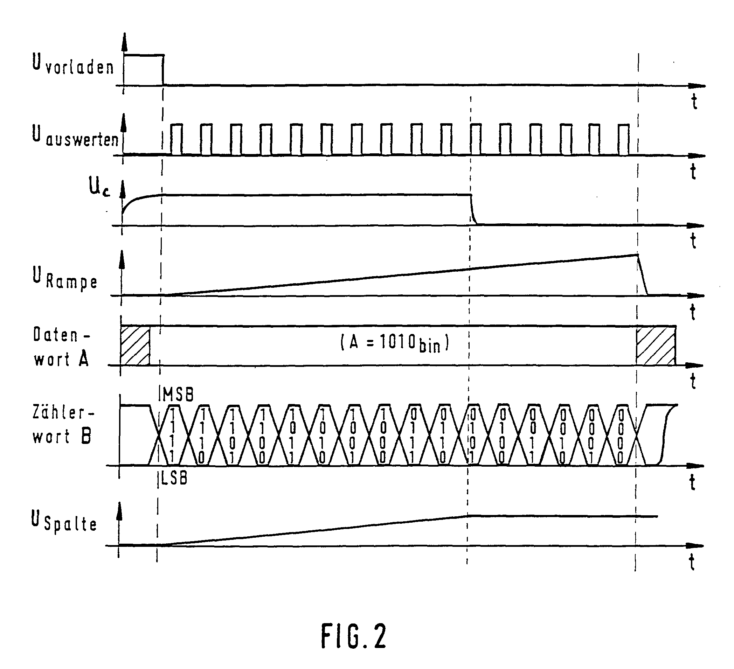

Fig. 2 zeigt die zeitlichen Verläufe der Spannungen der Schaltung nach Fig. 1. Zunächst wird die Kapazitätsspannung $U_C$ auf die Batteriespannung $U_{DD}$ aufgeladen und behält diesen Wert konstant bei. Dann beginnt die eigentliche Digital/Analog-Wandlung durch Anstieg der Referenzspannung $U_{Rampe}$ und gleichzeitiges Dekrementieren des Zählerwortes B von seinem Maximalwert "1111". Der analoge Spannungswert $U_{Spalte}$ am Ausgang der Schaltung läuft parallel mit der Spannung $U_{Rampe}$ hoch, bis das Zählerwort B dem Komplement des Datenworts A entspricht. Im dargestellten Beispiel ist A = $1010_{bin}$, d. h. das Komplement $\bar{A}$ ist $0101_{bin}$. Sobald das Zählerwort B diesen Wert erreicht, sind die Ausgänge aller NAND-Gatter auf dem logischen Pegel "1" und sämtliche Schalter $S_0$ bis $S_3$ sowie der Schalter $S_A$ werden geschlossen, so daß sich die Kapazität C entladen kann. Gleichzeitig wird dadurch der Schalter $S_R$ geöffnet, d. h. die Ausgangsspannung $U_{Spalte}$ behält den zu diesem Zeitpunkt erreichten Wert der Spannung $U_{Rampe}$ bei.

In Fig. 3 ist noch einmal eine Wahrheitstabelle einer NAND-Verknüpfung zweier digitaler Worte A und B dargestellt. Das Datenwort A lautet $1010_{bin}$. Das Zählerwort B wird vom Wert $1111_{bin}$ aus dekrementiert. Sobald das Zählerwort den Wert $0101_{bin} = \bar{A}$ aufweist, lautet das Ergebnis der NAND-Verknüpfung von A und B $1111_{bin}$. Dieser Wert wird zwar bei weiterem Dekrementieren des Zählerwortes B noch dreimal erreicht, doch ist dann die Digital/Analog-Wandlung bereits abgeschlossen, d. h. die Kapazität C wieder entladen. $U_{Spalte}$ kann sich dann nicht mehr ändern.

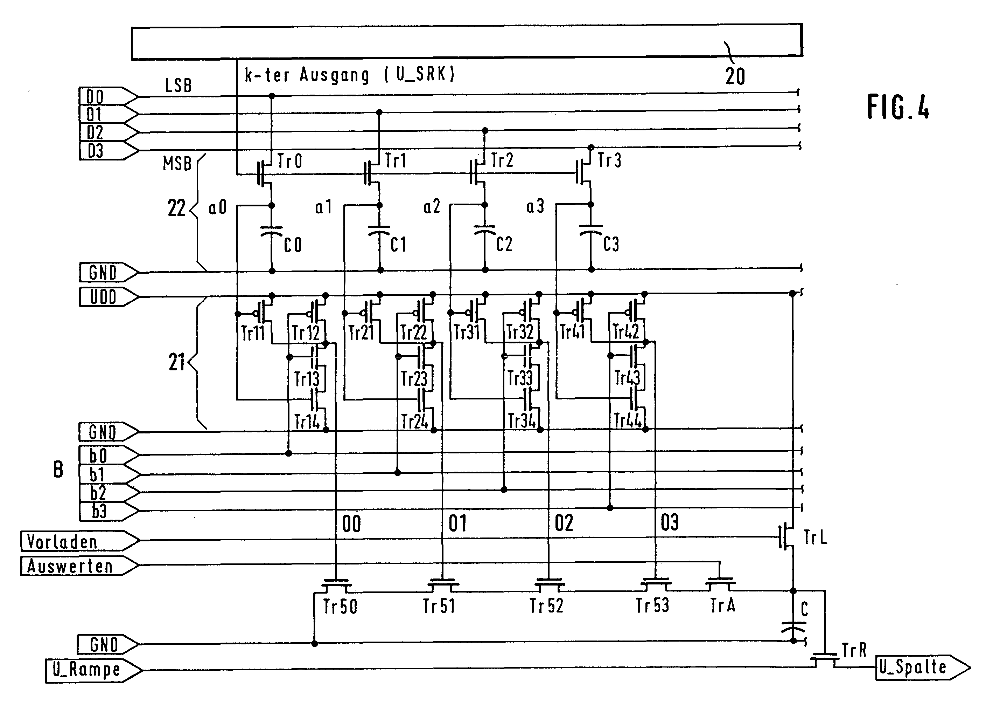

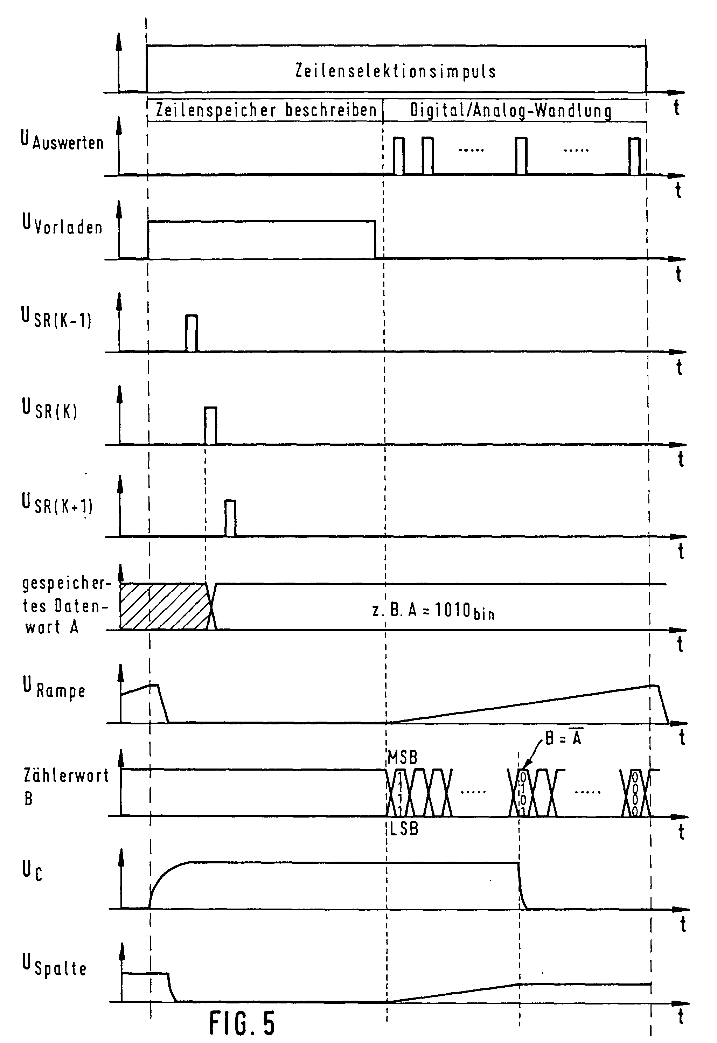

Fig. 4 zeigt eine Schaltung zur Ansteuerung einer Spalte eines Flüssigkristall-Bildschirms. Es sind wieder N=4 NAND-Gatter 21 dargestellt, die hier durch Dünnfilmtransistoren realisiert sind. Die Bits $a_0$ bis $a_3$ eines Datenwortes A liegen in einem Datenspeicher 22 an. Der Datenspeicher 22 wird mit Hilfe eines Schieberegisters 20 mit den Bits der Datenleitungen $D_0$ bis $D_3$ beschrieben. Das Datenwort A kodiert den Grauwert, der als analoger Wert $U_{Spalte}$ eine Spalte eines Flüssigkristall-Bildschirms ansteuern soll. Während der Ausgang des Schieberegisters 20 eine hohe Spannung aufweist, werden die Speicherkondensatoren $C_0$ bis $C_3$ über die Transistoren Tr0 bis Tr3 auf die momentanen Spannungen auf den Datenleitungen $D_0$ bis $D_3$ aufgeladen. Während der Speicher 22 beschrieben wird, weist die Vorladespannung $U_{vorladen}$ einen hohen Wert auf. Dadurch wird die Kapazität C auf die Spannung $U_{DD}$ aufgeladen, die hoch genug ist, damit der Transistor TrR leitet. Hierdurch wird die zugehörige Spalte des Flüssigkristall-Bildschirms elektrisch mit der Leitung R verbunden, die die rampenförmige Referenzspannung $U_{Rampe}$ führt. Die Spaltenspannung $U_{Spalte}$ folgt somit der Rampenspannung $U_{Rampe}$. Gleichzeitig besitzt die Auswertespannung $U_{auswerten}$ während der Einschreibephase des Datenwortes A in den Speicher 22 einen niedrigen Wert, so daß der Transistor TrA gesperrt ist. Hierdurch wird ein unerwünschtes Entladen von C sicher vermieden. Wenn sämtliche Speicher der Spalten einer Zeile beschrieben sind, beginnt die Phase der Digital/Analog-Wandlung. Die Rampenspannung $U_{Rampe}$ beginnt mit dem Durchlaufen des Bereiches $U_{min}$ bis $U_{max}$. Gleichzeitig wird ein externer Zähler B gestartet, der von seinem Maximalwert $1111_{bin}$ bis zum Wert $0000_{bin}$ dekrementiert wird. Das Datenwort A und das Zählerwort B werden durch die NAND-Gatter 21 miteinander verknüpft. Falls die Bedingung B = $\bar{A}$ erfüllt ist, sind sämtliche Ausgänge $O_0$ bis $O_3$ der NAND-Gatter 21 auf einem hohen Spannungspegel, wodurch die als Schalter wirkenden Transistoren Tr50 bis Tr53 leiten. Sobald $U_{auswerten}$ auf einen hohen Pegel wechselt, leitet auch der Transistor TrA, so daß sich die Kapazität C über die Transistoren Tr50 bis Tr53 und TrA entladen kann. Der Transistor TrR sperrt, wodurch der zuvor erreichte Spannungswert $U_{Spalte}$ auf der Spalte gespeichert bleibt, bis ein neuer Zeilenselektionsimpuls das Öffnen aller Bildpunktschalter bewirkt. Der Spannungswert $U_{Spalte}$ bleibt somit für eine Bildwiederholdauer im Bildpunktspeicher erhalten. Die zur Fig. 4 gehörigen Spannungsverläufe sind in Fig. 5 dargestellt und entsprechen im wesentlichen den in Fig. 2 gezeigten Verläufen.

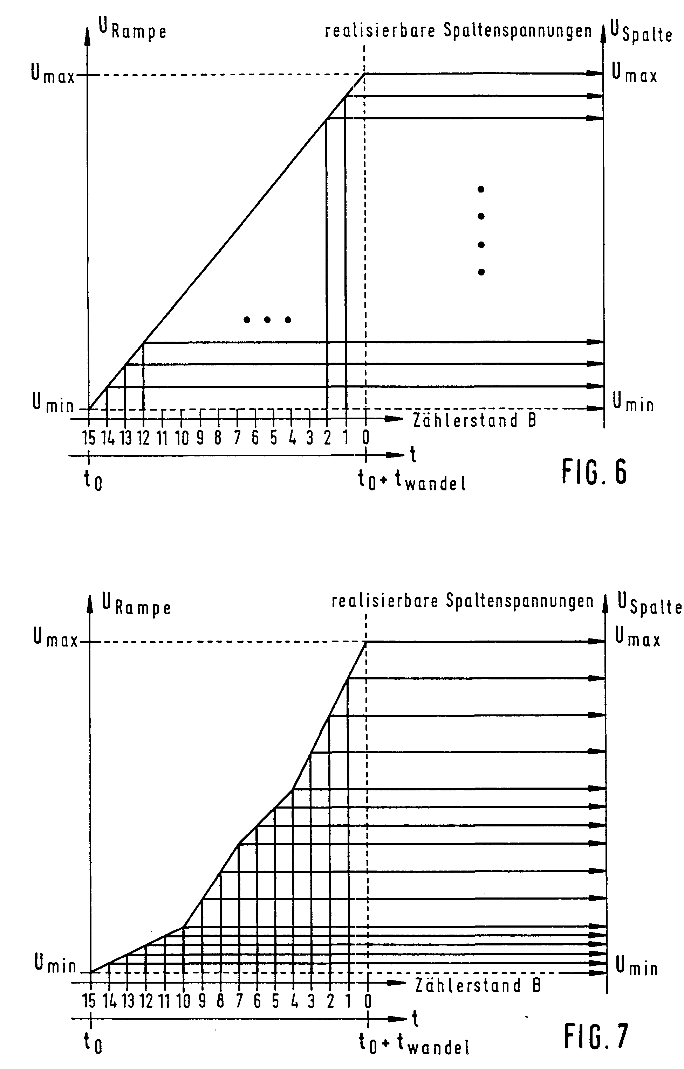

Die Fig. 6 und 7 zeigen jeweils zeitliche Verläufe der Referenzspannung $U_{Rampe}$. In Fig. 6 ist ein linearer rampenförmiger Verlauf der Spannung $U_{Rampe}$ dargestellt. Da die Zeitpunkte der Dekrementierung des Zählerwortes B äquidistant sind, sind damit auch die realisierbaren Spaltenspannungen $U_{Spalte}$ äquidistant. In Fig. 7 hingegen ist der rampenförmige Verlauf der Rampenspannung $U_{Rampe}$ nichtlinear. Dadurch sind auch die realisierbaren Spaltenspannungen $U_{Spalte}$ unregelmäßig zwischen dem Minimalwert $U_{min}$ und dem Maximalwert $U_{max}$ verteilt. Im in Fig. 7 dargestellten Beispiel ist durch den flachen Verlauf der Spannung $U_{Rampe}$ zu Beginn des Zählvorgangs die Auflösung von realisierbaren Werten der Spaltenspannung $U_{Spalte}$ im Bereich kleiner Spannungen sehr hoch.

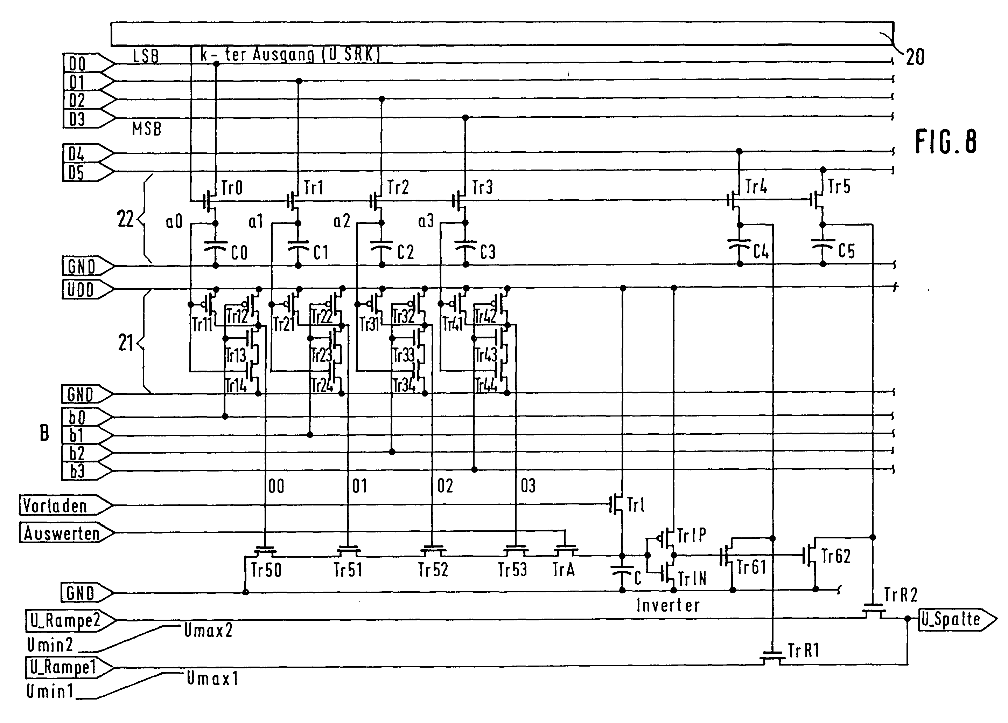

Die in Fig. 8 gezeigte Schaltung entspricht weitgehend der in Fig. 4 gezeigten, weist jedoch zwei unterschiedliche Referenzspannungen $U_{Rampe1}$ und $U_{Rampe2}$ auf, zwischen denen wahlweise umgeschaltet werden kann. Die Auswahl der Rampenspannungen $U_{Rampe1}$ und $U_{Rampe2}$ wird dabei über zwei Datenbits D4 und D5 vorgenommen. Die Werte von D4 und D5 werden in zwei Speicherkondensatoren C4 und C5 eingeschrieben. Durch Beschreiben der Speicherkapazität C4 mit einer hohen Spannung und C5 mit einer niedrigen Spannung oder umgekehrt wird entweder der Transistor TrR1 oder TrR2 leitend, so daß die Spaltenspannung $U_{Spalte}$ entweder der Rampenspannung $U_{Rampe1}$ oder $U_{Rampe2}$ entspricht. Da jeweils nur eine der beiden Rampenspannungen $U_{Rampe1}$ oder $U_{Rampe2}$ ausgewählt werden darf, darf nur eines der Rampenselektionsbits D4 oder D5 den logischen Wert "1" besitzen. Während der Digital/Analog-Wandlung durchlaufen nun die Spannungen $U_{Rampe1}$ den Bereich $U_{Rampe1min}$ bis $U_{Rampe1max}$, die Spannung $U_{Rampe2}$ den Bereich $U_{Rampe2min}$ bis $U_{Rampe2max}$. Wird $U_{Rampe1min} < U_{Rampe1max} < U_{Rampe2min} < U_{Rampe2max}$ gewählt, so sind mit der Schaltung nach Fig. 8 doppelt soviel Grauwerte darstellbar wie bei der Schaltung nach Fig. 4. Statt dem Transistor TrR in der Schaltung nach Fig. 4 werden nun TrR1 und TrR2 verwendet, für deren Abschaltung die Transistoren Tr61, Tr62 sowie ein Inverter verwendet werden. Solange $U_C$ eine hohe Spannung aufweist, liefert der Inverterausgang eine niedrige Spannung. Dadurch werden die Transistoren Tr61 und Tr62 gesperrt, und die auf den Speicherkapazitäten $C_4$ und $C_5$ gespeicherten Spannungen bleiben unverändert. Wird nun C entladen, so ändert sich die Spannung am Inverterausgang auf einen hohen Wert $U_{DD}$ und die Transistoren Tr61 und Tr62 leiten, so daß beide Speicherkapazitäten $C_4$ und $C_5$ sicher entladen werden. Dadurch beginnt der zuvor leitende Transistor TrR1 bzw. TrR2 zu sperren, und der zuletzt erreichte Spannungswert $U_{Spalte}$ bleibt erhalten.

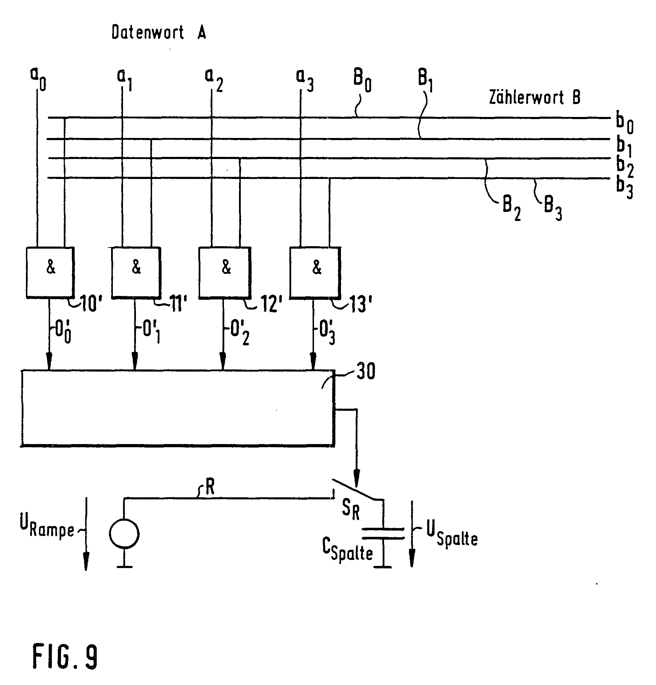

Fig. 9 zeigt ein verallgemeinertes Prinzipschaltbild einer D/A-Wandler-Schaltungsanordnung mit beliebiger logischer Verknüpfung zweier Worte A und B mit jeweils N=4 Bit. Die beliebigen logischen Verknüpfungen werden durch die mit einem "&" gekennzeichneten logischen Gatter 10' - 13' durchgeführt. Die Ausgänge $O_0'$ - $O_3'$ der Gatter 10' - 13' werden von einer Auswerteschaltung 30 ausgewertet, deren Aufbau von der Art der logischen Verknüpfung abhängt. Sie hat die Aufgabe, den Schalter SR zu öffnen, sobald alle Ausgänge $O_0'$ - $O_3'$ der Gatter 10' - 13' eine logische "1" bzw. eine logische "0" aufweisen. Da die Auswerteschaltung 30 bei den logischen Verknüpfungen von A und B lediglich das erste Auftreten von $1111_{bin}$ bzw. $0000_{bin}$ an den Gatterausgängen detektieren muss, ist auch ihre Realisierung mit geringem Aufwand möglich, beispielsweise durch eine Kapazität, die entladen wird, sobald $B = \bar{A}$ ist.

Mit Schaltungsanordnungen, die nach dem erfindungsgemäßen Digital/Analog-Wandlungsprinzip arbeiten, lassen sich Flüssigkristall-Bildschirme beispielsweise mit digitalen Videosignalen ansteuern. Die Bildinformation wird für alle Spalten zunächst digital gespeichert. Durch das digitale Prinzip lässt sich die Störempfindlichkeit stark vermindern. Die Schaltungsanordnung ist aufgrund des digitalen Eingangssignals auch sehr gut für digitale Endgeräte geeignet, da z. B. die Signalverarbeitung heutiger Fernsehgeräte hauptsächlich digital erfolgt und ferner die Fernsehsignalübertragung in Zukunft digital erfolgen wird. Die Digital/Analog-Wandlung erfolgt dabei für alle Spalten des Bildes gleichzeitig. Dies erhöht die Einschreibedauer für alle Spaltenleitungen. Die erfindungsgemäße Ansteuerungsmethode bietet außerdem den Vorteil einer Auflösung von N Bit zwischen weitgehend beliebigen Werten $U_{min}$ und $U_{max}$. Die Digital/Analog-Wandlerkennlinie ist im Gegensatz zu Wandlerschaltungen mit binär gewichteten geschalteten Kapazitäten, bei denen das Verhältnis der geschalteten Kapazitäten zur Ausgangskapazität die Kennlinie bestimmt, unabhängig von der kapazitiven Last am Ausgang des Digital/Analog-Wandlers. Außerdem ist bei Wandlern mit binär gewichteten geschalteten Kapazitäten der Platzbedarf für den Wandler proportional zur Anzahl $2^N$ der darstellbaren Graustufen, während bei dem erfindungsgemäßen Digital/Analog-Wandler der Schaltungsaufwand lediglich proportional zu N steigt. Die erfindungsgemäße Schaltungsanordnung läßt sich außerdem im Gegensatz zu Wandlern mit R-2R-Widerstandsnetzwerken, Konstantstromquellen und/oder Operationsverstärkern sehr gut in Dünnfilmtechnik herstellen. Sie ist daher besonders geeignet für die Integration auf einem Bildschirmsubstrat.

## Patentansprüche

1. Verfahren zur Wandlung eines digitalen Datenwortes mit N Bit in einen analogen Spannungswert durch Vergleich des digitalen Datenwortes mit einer analogen Referenzspannung mit rampenförmigem zeitlichen Verlauf, **dadurch gekennzeichnet, dass** eine bitweise AND-, NAND-, OR- oder NOR-Verknüpfung des digitalen Datenwortes (A) mit einem N-Bit-Zählerwort (B) durchgeführt wird, das synchron zum zeitlichen Verlauf der Referenzspannung ($U_{Rampe}$) bei einer AND- oder NAND-Verknüpfung von seinem maximalen Wert ("1111") ausgehend dekrementiert wird bzw. bei einer OR- oder NOR-Verknüpfung von seinem minimalen Wert ("0000") ausgehend inkrementiert wird, und dass sobald alle Ausgänge der logischen Gatter erstmals gleichzeitig eine logische "1" oder eine logische "0" liefern, d. h. das Zählerwort (B) einen Wert erreicht, der dem Komplement (A) des digitalen Datenwortes (A) entspricht, der dann erreichte Wert der Referenzspannung ($U_{Rampe}$) als analoger Spannungswert ($U_{Spalte}$) ausgegeben wird.

2. Verfahren nach Anspruch 1, **dadurch gekennzeichnet, dass** der rampenförmige zeitliche Verlauf der Referenzspannung ($U_{Rampe}$) nicht linear ist.

3. Verfahren nach Anspruch 1 oder 2, **dadurch gekennzeichnet, dass** mehrere Referenzspannungen ($U_{Rampe1}$, $U_{Rampe2}$) mit unterschiedlichem zeitlichen Verlauf zur Auswahl zur Verfügung stehen.

4. Schaltungsanordnung zur Wandlung eines digitalen Datenwortes mit N Bit in einen analogen Spannungswert durch Vergleich des digitalen Datenwortes mit einer analogen Referenzspannung mit rampenförmigem zeitlichem Verlauf nach einem Verfahren nach einem der Ansprüche 1 bis 3, mit N logischen Gattern (10' bis 13') des gleichen Typs zur bitweisen AND-, NAND-, OR- oder NOR- Verknüpfung des digitalen Datenwortes (A) mit einem N-Bit-Zählerwort (B), einer Einrichtung zum Dekrementieren des Zählerwortes (B) von einem maximalen Wert ("1111") aus synchron zum zeitlichen Verlauf der Referenzspannung ($U_{Rampe}$), sofern die Gatter (10' bis 13') AND- oder NAND-Gatter sind, und einer Einrichtung zum Inkrementieren des Zählerwortes (B) von seinem minimalen Wert ("0000") aus synchron zum zeitlichen Verlauf der Referenzspannung ($U_{Rampe}$), sofern die Gatter (10' bis 13') OR- oder NOR-Gatter sind, und mit einer Auswerteschaltung (30) für die Ausgangssignale ($O_0'$ - $O_3'$) der N Gatter (10' bis 13'), deren Ausgangssignal die Ausgabe des Referenzspannungswertes ($U_{Rampe}$)als analogen Ausgangsspannungswert ($U_{Spalte}$) steuert.

5. Schaltungsanordnung nach Anspruch 4, **dadurch gekennzeichnet, dass** die Auswerteschaltung (30) bei Verwendung von NAND-Gattern (10' - 13') mindestens eine Kapazität (C) und höchstens N+3 weitere Schaltungselemente ($S_0$ bis $S_3$, $S_A$, $S_L$, $S_R$) aufweist.

6. Schaltungsanordnung nach Anspruch 5, **dadurch gekennzeichnet, dass** die höchstens N+3 weiteren Schaltungselemente ($S_0$ bis $S_3$, $S_A$, $S_L$, $S_R$) Schalter sind.

7. Schaltungsanordnung nach einem der Ansprüche 4 bis 6, **dadurch gekennzeichnet, dass** sie in Dünnfilmtechnologie realisiert ist.

8. Digitale Ansteuerschaltung für die Datenleitungen eines Flüssigkristall-Bildschirms mit matrixförmiger Anordnung von Bildpunkten, die je Datenleitung einen Speicher (22) für ein digitales Datenwort (A), eine Schaltungsanordnung nach einem der Ansprüche 4 bis 7 und einen mit allen Schaltungsanordnungen der Datenleitungen verbundenen Zähler aufweist.

9. Ansteuerschaltung nach Anspruch 8, **dadurch gekennzeichnet, dass** sie mit der Bildpunktmatrix des Flüssigkristall-Bildschirms auf einem gemeinsamen Substrat und in einem gemeinsamen Dünnfilmtechnologieprozess herstellbar ist.

**Claims**

1. Method of converting a digital data word having N bits into an analog voltage value by comparing the digital data word with an analog reference voltage having a ramp-like time curve, **characterized in that** a bit-wise AND-, NAND-, OR- or NOR-connection of the digital data word (A) with an N-bit counter word (B) is effected, which, synchronously with the time curve of the reference voltage ($U_{Rampe}$), with an AND- or NAND connection is decremented starting from its maximum value ("1111") or with an OR- or NOR-connection is incremented starting from its minimum value ("0000"), and **in that** as soon as all the outputs of the logic gates first simultaneously deliver a logical "1" or a logical "0", i.e. the counter word (B) reaches a value which corresponds to the complement (A) of the digital data word (A), the value then reached of the reference voltage ($U_{Rampe}$) is given out as analog voltage value. ($U_{Spalte}$).

2. Method according to Claim 1, **characterized in that** the ramp-like time curve of the reference voltage ($U_{Rampe}$) is non-linear.

3. Method according to Claim 1 or 2, **characterized in that** selection can be made from a plurality of available reference voltages ($U_{Rampe1}$, $U_{Rampe2}$) having different time curves.

4. Circuit arrangement for the conversion of a digital data word having N bits into an analog voltage value by comparing the digital data word with an analog reference voltage having a ramp-like time curve according to a method according to one of Claims 1 to 3, said circuit arrangement having N logic gates (10' to 13') of the same type for the bit-wise AND-, NAND-, OR- or NOR-connection of the digital data word (A) with an N-bit counter word (B), means for decrementing the counter word (B) from a maximum value ("1111") synchronously with the time curve of the reference voltage ($U_{Rampe}$) if the gates (10' to 13') are AND- or NAND-gates, and means for incrementing the counter word (B) from its minimum value ("0000") synchronously with the time curve of the reference voltage ($U_{Rampe}$) if the gates (10' to 13') are OR- or NOR-gates, and having an evaluating circuit (30) for the output signals ($0_0'$ - $0_3'$) of the N gates (10' to 13'), the output signal of which controls the output of the reference voltage value ($U_{Rampe}$) as analog output voltage value($U_{Spalte}$).

5. Circuit arrangement according to Claim 4, **characterized in that** the evaluating circuit (30), when NAND-gates (10' - 13') are used, has at least one capacitor (C) and at most N+3 additional circuit elements ($S_0$ to $S_3$, $S_A$, $S_L$, $S_R$).

6. Circuit arrangement according to Claim 5, **characterized in that** the at most N+3 additional circuit elements ($S_0$ to $S_3$, $S_A$, $S_L$, $S_R$) are switches.

7. Circuit arrangement according to one of Claims 4 to 6, **characterized in that** it is made using thin-film technology.

8. Digital control circuit for the data lines of a liquid crystal display with matrix-like arrangement of picture elements, said digital control circuit having for each data line a memory (22) for a digital data word (A), a circuit arrangement according to one of Claims 4 to 7 and a counter connected to all the circuit arrangements of the data lines.

9. Control circuit according to Claim 8, **characterized in that** it can be manufactured with the picture-element matrix of the liquid crystal display on a shared substrate and using a combined thin-film technology process.

**Revendications**

1. Procédé pour convertir un mot de données numérique à N bits en une valeur de tension analogique par comparaison du mot de données numérique à une tension de référence analogique avec une variation dans le temps en forme de rampe, **caractérisé en ce qu'**une opération logique ET, NON-ET, OU ou NON-OU du mot de données numérique (A) est réalisée avec un mot de comptage à N bits (B) qui, de manière synchrone avec la variation dans le temps de la tension de référence ($U_{Rampe}$), est respectivement décrémenté à partir de sa valeur maximale ("1111") pour une opération ET ou NON-ET et incrémenté à partir de sa valeur minimale ("0000") pour une opération OU ou NON-OU, et **en ce que**, dès que toutes les sorties de la porte logique délivrent pour la première fois en même temps un "1" logique ou un "0" logique, c'est-à-dire que le mot de comptage (B) atteint une valeur qui correspond au complément (A) du mot de données numérique (A), la valeur de la tension de référence ($U_{Rampe}$) alors atteinte est sortie en tant que valeur de tension analogique ($U_{Spalte}$).

2. Procédé selon la revendication 1, **caractérisé en ce que** la variation dans le temps en forme de rampe de la tension de référence ($U_{Rampe}$) n'est pas linéaire.

3. Procédé selon la revendication 1 ou 2, **caractérisé en ce que** plusieurs tensions de référence ($U_{Rampe1}$, $U_{Rampe2}$) avec une variation dans le temps différente peuvent être sélectionnées.

4. Agencement de circuit pour convertir un mot de données numérique à N bits en une valeur de tension analogique par comparaison du mot de données numérique à une tension de référence analogique avec une variation dans le temps en forme de rampe selon un procédé selon l'une des revendications 1 à 3, ayant N portes logiques (10' à 13') du même type pour l'opération logique ET, NON-ET, OU ou NON-OU du mot de données numérique (A) avec un mot de comptage à N bits (B), un dispositif pour décrémenter le mot de comptage (B) à partir d'une valeur maximale ("1111") de manière synchrone avec la variation dans le temps de la tension de référence ($U_{Rampe}$) si les portes (10' à 13') sont des portes ET ou NON-ET, et un dispositif pour incrémenter le mot de comptage (B) à partir de sa valeur minimale ("0000") de manière synchrone avec la variation dans le temps de la tension de référence ($U_{Rampe}$) si les portes (10' à 13') sont des portes OU ou NON-OU, et ayant un circuit d'évaluation (30) pour les signaux de sortie ($0_0'$-$0_3'$) des N portes (10' à 13'), dont le signal de sortie commande la sortie de la valeur de tension de référence ($U_{Rampe}$) en tant que valeur de tension analogique de sortie ($U_{Spalte}$).

5. Agencement de circuit selon la revendication 4, **caractérisé en ce que**, en cas d'emploi de portes NON-ET (10'-13'), le circuit d'évaluation (30) présente au moins une capacité (C) et au plus N+3 autres éléments de circuit ($S_0$ à $S_3$, $S_A$, $S_L$, $S_R$).

**6.** Agencement de circuit selon la revendication 5, **caractérisé en ce que** les au plus N+3 autres éléments de circuit ($S_0$ à $S_3$, $S_A$, $S_L$, $S_R$) sont des commutateurs.

**7.** Agencement de circuit selon l'une des revendications 4 à 6, **caractérisé en ce qu'**il est réalisé en technologie à couche mince.

**8.** Circuit de commande numérique pour les lignes de données d'un écran à cristaux liquides avec agencement matriciel de points d'image, lequel comporte, pour chaque ligne de données, une mémoire (22) pour un mot de données numérique (A), un agencement de circuit selon l'une des revendications 4 à 7, et un compteur connecté à tous les agencements de circuit des lignes de données.

**9.** Circuit de commande selon la revendication 8, **caractérisé en ce qu'**il peut être fabriqué avec la matrice de points d'image de l'écran à cristaux liquides sur un substrat commun et dans un processus commun de technologie à couche mince.

FIG. 1

FIG.2

| Datenwort A | Zählerwort B | Ergebnis der bitweisen NAND-Verknüpfung von A und B |
|---|---|---|
| z.B. $1010_{bin}$ | $1111_{bin}$ | $0101_{bin}$ |
| dto. | $1110_{bin}$ | $0101_{bin}$ |
| dto. | $1101_{bin}$ | $0111_{bin}$ |
| dto. | $1100_{bin}$ | $0111_{bin}$ |
| dto. | $1011_{bin}$ | $0101_{bin}$ |
| dto. | $1010_{bin}$ | $0101_{bin}$ |
| dto. | $1001_{bin}$ | $0111_{bin}$ |
| dto. | $1000_{bin}$ | $0111_{bin}$ |
| dto. | $0111_{bin}$ | $1101_{bin}$ |
| dto. | $0110_{bin}$ | $1101_{bin}$ |
| dto. | $0101_{bin}$ | $1111_{bin}$ |
| dto. | $0100_{bin}$ | $1111_{bin}$ |
| dto. | $0011_{bin}$ | $1101_{bin}$ |
| dto. | $0010_{bin}$ | $1101_{bin}$ |
| dto. | $0001_{bin}$ | $1111_{bin}$ |
| dto. | $0000_{bin}$ | $1111_{bin}$ |

FIG. 3

FIG.4

EP 0 701 331 B1

Zeilenselektionsimpuls

Zeilenspeicher beschreiben    Digital/Analog-Wandlung

$U_{Auswerten}$

$U_{Vorladen}$

$U_{SR(K-1)}$

$U_{SR(K)}$

$U_{SR(K+1)}$

gespeichertes Datenwort A

z. B. $A = 1010_{bin}$

$U_{Rampe}$

$B = \overline{A}$

Zählerwort B

MSB

LSB

$U_C$

$U_{Spalte}$

FIG. 5

FIG. 6

FIG. 7

EP 0 701 331 B1

LSB k – ter Ausgang (U SRK)

D0
D1
D2
D3

MSB

D4
D5

**FIG.8**

Tr0  Tr1  Tr2  Tr3  Tr4  Tr5

22

a0  a1  a2  a3

C0  C1  C2  C3  C4  C5

GND

UDD

21

Tr11 Tr12  Tr21 Tr22  Tr31 Tr32  Tr41 Tr42

Tr13  Tr23  Tr33  Tr43

Tr14  Tr24  Tr34  Tr44

GND

b0
B b1
b2
b3

00  01  02  03

Vorladen  Trl

Auswerten

TrlP

Tr50  Tr51  Tr52  Tr53  TrA  C  TrlN  Tr61  Tr62

GND

Inverter

TrR2

U_Rampe2  U_Spalte
Umax2

U_Rampe1  TrR1
Umin1  Umax1

20

Datenwort A

FIG.9